**Europäisches Patentamt**

**European Patent Office**

**Office européen des brevets**

(19)

(11) Publication number: **0 181 344**
**B1**

# (12) EUROPEAN PATENT SPECIFICATION

(45) Date of publication of patent specification: **09.03.88**

(21) Application number: **85901825.1**

(22) Date of filing: **25.03.85**

(86) International application number:
**PCT/US85/00502**

(87) International publication number:
**WO 85/04759 24.10.85 Gazette 85/23**

(51) Int. Cl.⁴: **H 01 L 21/22,** H 01 L 21/225,
H 01 L 21/74

## (54) METHOD OF TRANSFERRING IMPURITIES BETWEEN DIFFERENTLY DOPED SEMICONDUCTOR REGIONS.

(30) Priority: **09.04.84 US 597924**

(43) Date of publication of application:
**21.05.86 Bulletin 86/21**

(45) Publication of the grant of the patent:
**09.03.88 Bulletin 88/10**

(84) Designated Contracting States:
**DE FR GB NL**

(56) References cited:
**EP-A-0 009 910**
**DE-A-2 255 107**

**IBM Technical Disclosure Bulletin, vol. 24, no. 6, November 1981 (New York, US) S. Dash et al.: "Method to fabricate polysilicon or polycide buried contacts to diffused lines in a MOSFET", pages 2863-2866**

**Journal of Applied Physics, vol. 49, no. 12, December 1978 (New York, US) M. Wittmer et al.: "The redistribution of implanted dopants after metalsilicide formation", pages 5827-5834**

(73) Proprietor: **AMERICAN TELEPHONE AND TELEGRAPH COMPANY**
**550 Madison Avenue**
**New York, NY 10022 (US)**

(72) Inventor: **OH, Kye, Hwan**
**216 North Broad Street**
**Allentown, PA 18104 (US)**

(74) Representative: **Watts, Christopher Malcolm Kelway, Dr. et al**
**Western Electric Company Limited 5, Mornington Road**
**Woodford Green Essex, IG8 0TU (GB)**

Courier Press, Leamington Spa, England.

## Description

### Background of the Invention

This invention relates to a process for transferring impurities from region to region of a semiconductor device. In one use of the invention, the transferred impurities are used to define a surface area of a region to which a conductive contact is to be made.

As the size of doped regions in semiconductor integrated circuit substrates shrink, to make ever smaller devices, the size of the electrical contacts to those regions likewise shrink. A limiting factor is the minimum dimension that can be produced in a given technology. When the doped region to be contacted is itself of such minimum dimension, the contact "window" or opening through the usual insulating layer overlying the doped region cannot be made smaller than the doped region. As a result, owing to inevitable processing variations, the contact window is almost certainly partially non-aligned with or offset from the region to be contacted, hence will generally overlie an adjacent, differently doped region. Thus, if a conductive contact is deposited within the window, it will short together the two adjacent regions, which is generally undesirable. A solution to this problem is to introduce impurities through the window to convert the overlapped portion of the adjacent doped region to the same doping of the doped region to be contacted. The impurities are, in the past, introduced by standard means, e.g., ion implantation. A problem with this, however, is that extra masking steps are often required to control the regions where these additional impurities are applied. The present invention provides an improved process for adding the additional impurities without the need for extra masking steps.

### Summary of the Invention

An impurity transfer layer is deposited within the window and is heated to cause migration of impurities from the doped region to be contacted to the portion of the adjacent doped region exposed by the window to convert such exposed portion to the doping type of the impurity source region. A requirement of the process is that the doping level of the region to be contacted (the impurity source region) is higher than that of the adjacent exposed region to be converted. The transfer layer comprises a material in which the impurities diffuse rapidly. The preferred transfer layer is polysilicon or amorphous silicon, or a silicon-rich material such as a refractory metal silicide, e.g. $TiSi_2$, $TaSi_2$ or $CoSi_2$. An advantage of using silicon rich materials as the transfer layer is that they can be left in place, after serving to redistribute the impurities, to form part of the contact structure.

### Brief Description of the Drawings

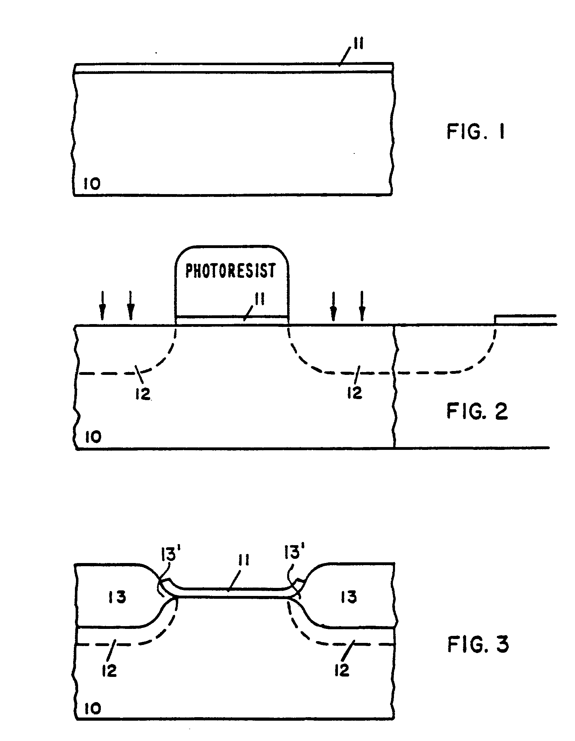

Figs. 1 to 14 describe various and typical processing sequences in which the present invention can be used.

### Detailed Description

The invention is described in connection with silicon semiconductor devices; it can be used with devices of other semiconductor materials, e.g., III—V or II—VI semiconductor bodies, and with other device structures.

Figs. 1—6 show a known process used, for example, in the fabrication of CMOS devices. Such process, by way of example of how the invention can be used, is now described.

Referring to Fig. 1, a p-type silicon substrate 10, doped to $2 \times 10^{15}/cm^3$, is shown covered with a conventional masking layer 11, e.g., of $SiO_2$. As shown in Fig. 2, the masking layer 11 is patterned using a photoresist layer, and two $p^+$ type regions 12 are formed, e.g., by ion implantation of boron, e.g. $6 \times 10^{12}/cm^2$ at 200 KeV. The space between the two regions 12 is preferably as narrow as possible, for maximum device packing density, and, to this end, the width of the layer 11 (from left to right in Fig. 2) is made as small as possible, i.e., it is of the minimum width obtainable with the patterning technology used. Various techniques are known to pattern layers, and the particular patterning technology used is a matter of choice for the user of the present invention.

Thereafter, the photoresist layer shown in Fig. 2 is removed, and a $SiO_2$ layer 13, e.g., 0.7 µm thick, is thermally grown on the surface portions of the substrate 10 not covered by the layer 11, as shown in Fig. 3. In such growth process, parts of the surface of the silicon substrate are converted to the $SiO_2$ layer 13, which layer, as shown, extends both inwardly into the substrate and upwardly from the original substrate surface. Also, some lateral growth 13' of the layer 13 beneath the layer 11 occur, as shown.

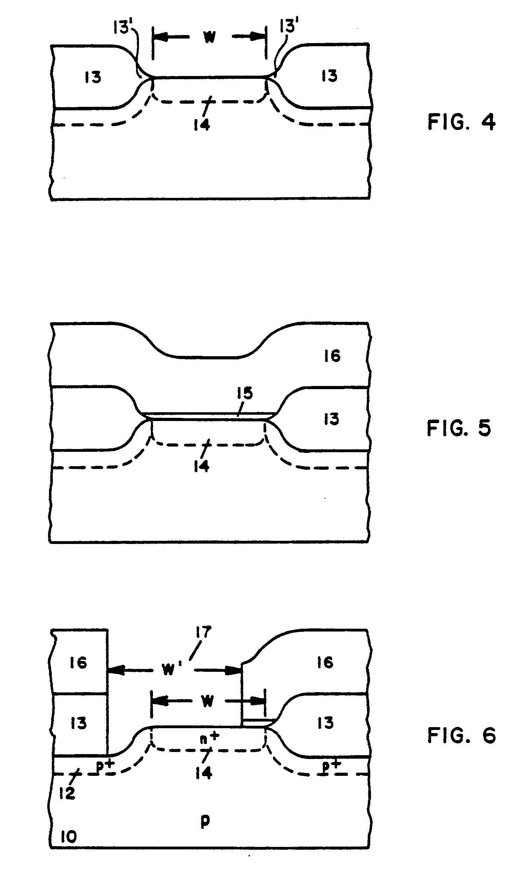

Next, as shown in Fig. 4, the layer is removed to expose a surface portion 14 of the substrate 10 via a window W through the $SiO_2$ layer 13. Because of the lateral growths 13' of the layer 13, the width of the window W and the width of the exposed region 14 are less than the width of the layer 11 originally used to define the window and the region n.

An oxide layer 15 (Fig. 5), e.g. 100 nm (1000 Å) in thickness, is then grown over the silicon exposed in the window and a phosphosilicate glass (PSG) or borophosphosilicate glass (BPSG) layer 16 is deposited thereover. The PSG or BPSG layer is typically of the order of 1 µm and serves a gettering function. Layer 15 serves as a buffer layer separating the phosphorus and boron in layer 16 from the active substrate region.

Contact window 17 (Fig. 6) is then cut in layers 15 and 16 down to contact region 14. Because, as previously explained, the width of region 14 is already less than the minimum dimension that can be obtained by the patterning process used, the width W' of the contact window 17 is unavoidably wider than the width of the region 14, and, as shown, a portion of the adjacent region 12 is exposed by the window 17. If a conductive layer were now deposited, to provide a contact to the region 14, the layer would short together the two regions 12 and 14.

As mentioned earlier, in one known prior solution, the structure shown in Fig. 6 is implanted with arsenic to convert the exposed portion of the $p^+$ region 12 to n-type thus eliminating the potential short when the contact is formed in window 17. However, at this stage of a CMOS process, the device being fabricated contains numerous contact windows, some of which expose $n^+$ regions similar to region 14, but others of which expose $p^+$ regions. Thus, the implantation of the arsenic requires an additional masking process to insure that the arsenic is implanted only through the correct windows.

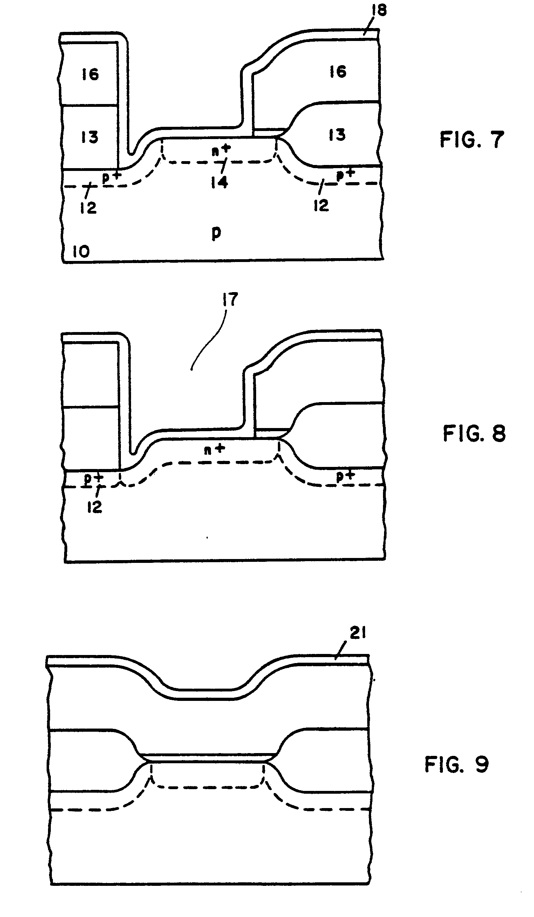

In accordance with this invention, and as shown in Fig. 7, a polysilicon or amorphous silicon layer 18 is non-selectively deposited over the substrate and into the contact window. This layer, typically of the order of 0.2 μ, serves as the transfer layer and is undoped. (It will be appreciated that this layer can, in some applications, be doped heavily n-type and thus serve as a primary source of impurities to compensation dope the exposed $p^+$ region 12. However, with CMOS technology, as herein described, the layer 18, to avoid selective depositions, is indoped.) The preferred method of deposition is CVD, to aid in sidewall coverage. However, in other device applications, such sidewall coverage is not necessary.

Using the conventional metal (aluminum) metallization process the PSG layer 16 would normally be heated to cause flow and rounding of the window corners for the metal to cover properly. However, using the technique described here, this step is unnecessary. The polysilicon layer 18 serves to complete otherwise incomplete electrical paths along the sidewalls. This is further described hereinafter.

With layer 18 in place, the assembly is heated to promote diffusion of n-type impurities from the region 14 through the transfer layer into the p-region 12 so as to convert a portion of that region to n-type (Fig. 8) and eliminate the potential short to the substrate. Recommended conditions for this treatment are 950°C for 60—90 minutes. In effect, the region 12 is reduced in size, the remaining, unconverted portion thereof not being exposed by the window 17.

Diffusion of p-type impurities from the region 12 in the opposite direction will also occur. This is why n-region 14 should be more heavily doped than p-region 12. Preferably, the difference in doping is greater at least by a factor of 10.

Also, impurities will diffuse in both directions within the substrate 10. Preferably, therefore, the transfer layer 18 should comprise a material in which the diffusion rate of impurities is significantly greater, e.g. twice, the diffusion rate in the substrate material.

The impurities in glass layer 16, e.g. phosphorus, boron, may themselves diffuse within transfer layer 18 to the contact region. That can be avoided if layer 18 is deposited, as by evaporation or sputtering, in a directional mode so that the sidewalls are not coated or are incompletely coated with the layer 18, i.e., so as not to provide a transfer path for the layer 18 impurities. Another approach to preventing outdiffusion and unwanted migration of impurities from the doped glass layer 16 is to cap it with deposited undoped oxide before the deposition of the polysilicon layer 18, as shown in Figs. 9—14. Fig. 9 is a stage in the process sequence that follows the stage shown in Fig. 5.

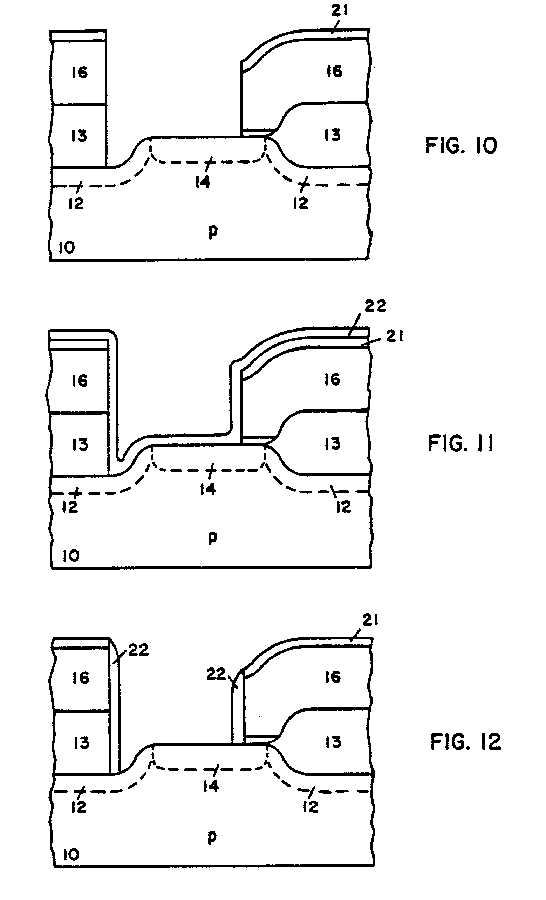

Fig. 9 shows an additional layer 21 which is of undoped oxide, for example, and is of the order of 0.2 μ thick. The contact window is opened as before, Fig. 10, and the sidewall capping layer 22, Fig. 11, again typically undoped $SiO_2$, is deposited preferably by CVD to cover the sidewalls as shown. Next, Fig. 12, layer 22 is etched anisotropically to remove the bottom portion of the layer at which time the portion of layer 22 along the top surface is also removed. However, due to the anisotropic etching, the portion of layer 22 along the sidewalls is incompletely etched and a sufficient thickness of layer 22 to serve as a cap for the sidewall of doped layer 16 remains. Suitable anisotropic etch techniques are known. See e.g. U.S. Patent 4,104,086 issued August 1, 1978.

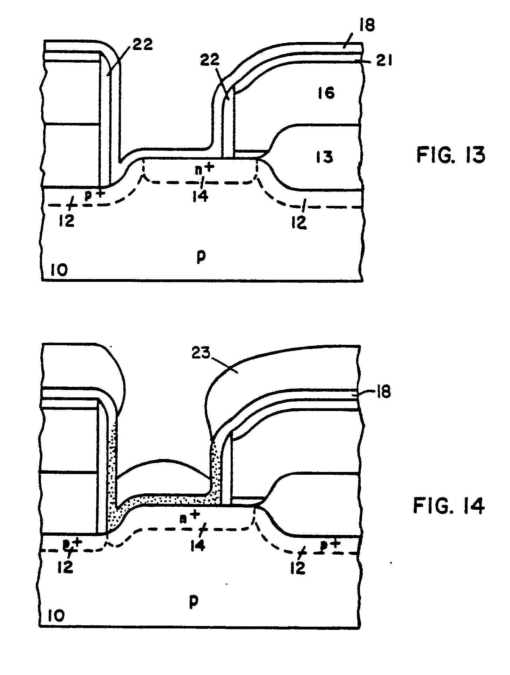

With the capping layers 21 and 22 in place, processing proceeds as before, i.e. Figs. 13 and 14 generally correspond to the steps illustrated in Figs. 7 and 8, respectively.

Fig. 14 also shows a metal layer 23, e.g. aluminum, deposited in a conventional manner, and shows incomplete sidewall coverage, a common problem. Using the transfer layer 18 according to this invention, however, discontinuities otherwise occurring in the electrical path provided by the metal layer are filled by the transfer layer which is electrically conductive owing to the presence therein of impurities from the region 14.

The basic concept of the invention is a technique for selective doping of one region in a semiconductor body with impurities obtained from another region of that semiconductor with the aid of a transfer layer external to the substrate. The regions may have the same or opposite conductivity types. The impurity source region and the impurity receiving region may be contiguous, as shown herein, or spaced apart.

**Claims**

1. A method of transferring impurities between differently doped semiconductor regions disposed at a surface of a substrate, characterized by forming a transfer layer (18) overlying the substrate (10) and in contact with both said regions (12, 14), and heating said transfer layer and said regions to cause transfer of impurities through said transfer layer between said regions.

2. The method of claim 1 in which said regions are of opposite conductivity type and the transfer of impurities causes the conversion of the conductivity type of one of the regions to that of the other.

3. The method according to claim 2 comprising forming a dielectric layer (13) over the substrate, selectively etching through said dielectric layer to form a window (17) therethrough substantially in vertical registration with one (14) of said regions but overlying, owing to process variations, a part of the other (12) regions, and depositing a layer comprising amorphous silicon or polysilicon into said window to form said transfer layer.

## Patentansprüche

1. Verfahren zum Überführen von Fremdstoffen zwischen unterschiedlich dotierten Halbleiterzonen, die bei einer Oberfläche eines Substrats angeordnet sind, gekennzeichnet durch Ausbilden einer Überführungsschicht (18), die auf dem Substrat (10) aufliegt und in Kontakt mit den beiden Zonen (12, 14) steht, und Erwärmen der Überführungsschicht und der Zonen, um eine Fremdstoffüberführung durch die Überführungsschicht zwischen den Zonen zu verursachen.

2. Verfahren nach Anspruch 1, bei dem die Zonen von entgegengesetzten Leitungstyp sind und die Fremdstoffüberführung die Umwandlung des Leitungstyps einer der Zonen in den· der anderen verursacht.

3. Verfahren nach Anspruch 2, umfassend Ausbilden einer dielektrischen Schicht (13) über dem Substrat, selektives Durchätzen der dielektrischen Schicht zur Ausbildung eines hindurchgehenden Fensters (17), das mit einer (14) der Zonen im wesentlichen vertikal ausgerichtet ist, aber aufgrund von Prozeßschwankungen einen Teil der anderen Zone (12) überlappt, und Niederschlagen einer amorphes Silicium oder Polysilicium umfassenden Schicht in das Fenster zur Ausbildung der Überführungsschicht.

## Revendications

1. Un procédé de transfert d'impuretés entre des régions de semiconducteur dopées différemment disposées sur un surface d'un substrat, caractérisée en ce que: on forme une couche de transfert (18) qui recouvre le substrat (10) et qui est en contact avec ces deux régions (12, 14) et on chauffe la couche de transfert et les régions précitées, pour provoquer le transfert d'impuretés par la couche de transfert, entre les régions.

2. Le procédé de la revendication 1, dans lequel les régions précitées ont des types de conductivité opposés et le transfert d'impuretés provoque la conversion du type de conductivité de l'une des régions, qui devient celui de l'autre région.

3. Le procédé selon la revendication 2, dans lequel on forme une couche diélectrique (13) sur le substrat, on attaque sélectivement cette couche diélectrique pour y former une fenêtre (17) la traversant pratiquement en alignement vertical avec l'une (14) des régions précitées, mais recouvrant une partie de l'autre région (12), à cause de variations dans le processus de fabrication, et on dépose dans la fenêtre une couche consistant en silicium amorphe ou en silicium polycristallin, pour former la couche de transfert.

0 181 344

FIG. 1

FIG. 2

PHOTORESIST

FIG. 3

FIG. 4

FIG. 5

FIG. 6

0 181 344

FIG. 7

FIG. 8

FIG. 9

3

FIG. 10

FIG. 11

FIG. 12

FIG. 13

FIG. 14